(19) Europäisches Patentamt
European Patent Office
Office européen des brevets

(11) **EP 1 984 995 B1**

(12) **EUROPÄISCHE PATENTSCHRIFT**

(45) Veröffentlichungstag und Bekanntmachung des Hinweises auf die Patenterteilung:
**17.11.2010 Patentblatt 2010/46**

(21) Anmeldenummer: 06722503.7

(22) Anmeldetag: **14.02.2006**

(51) Int Cl.:
***H02H 3/16*** *(2006.01)*          ***H02H 3/353*** *(2006.01)*
***G01R 31/08*** *(2006.01)*

(86) Internationale Anmeldenummer:
**PCT/DE2006/000291**

(87) Internationale Veröffentlichungsnummer:
**WO 2007/093137 (23.08.2007 Gazette 2007/34)**

(54) **VERFAHREN ZUM ERKENNEN EINES ERDSCHLUSSES IN EINEM GELÖSCHTEN ODER GEGENÜBER ERDPOTENTIAL ISOLIERTEN DREIPHASIGEN ENERGIEÜBERTRAGUNGSNETZ**

METHOD FOR IDENTIFYING AN EARTH FAULT IN A RESONANT-EARTHED THREE-PHASE POWER TRANSMISSION SYSTEM, OR A THREE-PHASE POWER TRANSMISSION SYSTEM WHICH IS ISOLATED FROM EARTH POTENTIAL

PROCEDE POUR DETECTER UNE FUITE A LA TERRE DANS UN RESEAU DE DISTRIBUTION D'ENERGIE TRIPHASE INUTILISE OU ISOLE PAR RAPPORT AU POTENTIEL DE LA TERRE

(84) Benannte Vertragsstaaten:
**AT BE BG CH CY CZ DE DK EE ES FI FR GB GR HU IE IS IT LI LT LU LV MC NL PL PT RO SE SI SK TR**

(43) Veröffentlichungstag der Anmeldung:
**29.10.2008 Patentblatt 2008/44**

(60) Teilanmeldung:
**10075133.8 / 2 226 913**

(73) Patentinhaber: **SIEMENS AKTIENGESELLSCHAFT**
**80333 München (DE)**

(72) Erfinder:
• **CLAUS, Michael**
**90579 Langenzenn (DE)**
• **KEREIT, Matthias**
**12159 Berlin (DE)**
• **STEYNBERG, Gustav**
**91338 Igensdorf (DE)**

(56) Entgegenhaltungen:
**DE-A1- 10 215 025     DE-B- 1 002 446**

• **PATENT ABSTRACTS OF JAPAN Bd. 2003, Nr. 12, 5. Dezember 2003 (2003-12-05) -& JP 2004 015862 A (MITSUBISHI ELECTRIC CORP), 15. Januar 2004 (2004-01-15)**
• **THOMAS BALDWIN ET AL: "Fault Locating in Ungrounded and High-Resistance Grounded Systems" IEEE TRANSACTIONS ON INDUSTRY APPLICATIONS, IEEE SERVICE CENTER, PISCATAWAY, NJ, US, Bd. 37, Nr. 4, Juli 2001 (2001-07), XP011022993 ISSN: 0093-9994**

## Beschreibung

Die Erfindung bezieht sich auf ein Verfahren mit den Merkmalen gemäß dem Oberbegriff des Anspruchs 1. Unter einem isolierten dreiphasigen Energieübertragungsnetz ist ein dreiphasiges Netz zu verstehen, bei dem der Sternpunkt des Netzes gegenüber dem Erdpotential isoliert ist. Unter einem gelöschten dreiphasigen Energieübertragungsnetz ist ein "kompensiertes" dreiphasiges Netz zu verstehen, bei dem der Sternpunkt des Energieübertragungsnetzes mit dem Erdpotential über eine Erdschlusslöschspule (z. B. Petersenspule) verbunden ist.

Ein derartiges Verfahren wird beispielsweise bei Schutzgeräten der Firma Siemens AG eingesetzt, die unter dem Produktnamen SIPROTEC 7SA511 und 7SA513 vertrieben werden. Bei dem vorbekannten Verfahren wird ein gelöschtes oder gegenüber Erdpotential isoliertes dreiphasiges Energieübertragungsnetz u. a. auf das Vorliegen eines Doppelerdschlusses überwacht. Hierzu wird der Erdstrom des Energieübertragungsnetzes gemessen und ein das Vorliegen eines Doppelerdschlusses anzeigendes Anregesignal erzeugt, wenn der Erdstrommesswert einen vorgegebenen Erdstrom-Schwellenwert überschreitet. Sobald ein derartiges Anregesignal gebildet worden ist, werden die Leiter-Erde-Schleifenimpedanzen des Energieübertragungsnetzes ausgewertet und auf das Vorliegen eines Doppelerdschlusses überprüft und es wird ggf. ein Fehlersignal gebildet, das die vom Doppelerdschluss betroffenen Phasen kennzeichnet.

Nachteilig bei dem vorbekannten Verfahren ist es, dass es in seltenen Fällen dazu kommen kann, dass aufgetretene Doppelerdschlüsse unerkannt bleiben, wenn die Kurzschlussstellen räumlich sehr weit voneinander getrennt sind.

Außerdem ist aus der deutschen Offenlegungsschrift DE 102 15 025 A1 ein Verfahren zum Erkennen von Erdschlüssen in Drehstromnetzen mit induktiv geerdetem Sternpunkt bekannt. Bei dem bekannten Verfahren wird eine einen ersten Fehler anzeigende Fehlererkennung aufrecht erhalten und bei Auftreten eines zweiten Fehlers geprüft, ob dieser zusätzlich oder anstatt des ersten Fehlers aufgetreten ist.

Zudem ist aus Patent Abstracts of Japan Band 2003, Nr. 12, 5. Dezember 2003 (2003-12-05) -& JP 2004 015862 A (MITSUBISHI ELECTRIC CORP), 15. Januar 2004 (2004-01-15) Zusammenfassung ein _Verfahren zum Erkennen von fehlerbehafteten Phasenleitern einer hochohmig geerdeten Energieversorgungsleitung bekannt.

Der Erfindung liegt die Aufgabe zugrunde, ein Verfahren der eingangs angegebenen Art dahingehend zu verbessern, dass es noch zuverlässiger als bisher, insbesondere im Falle eines Doppelerdschlusses bei räumlich weit auseinander liegenden Kurzschlussstellen, arbeitet.

Diese Aufgabe wird erfindungsgemäß dadurch gelöst, dass überprüft wird, ob die verketteten Phasenspannungen des Energieübertragungsnetzes relativ zueinander eine vorgegebene amplitudenbezogene Unsymmetrie-Schwelle überschreiten, dass ein entsprechendes Symmetriesignal gebildet wird, das eine Symmetrie oder Unsymmetrie anzeigt, und dass dieses Symmetriesignal bei der weiteren Überwachung herangezogen wird.

Das erfindungsgemäße Verfahren geht von der erfinderseitigen Erkenntnis aus, dass bei Doppelerdschlüssen mit räumlich weit voneinander getrennten Kurzschlussstellen der auftretende Erdstrom mitunter zu klein ist und damit allein einen Doppelerdschluss nicht in allen Fällen zuverlässig signalisieren kann. Erfindungsgemäß wird daher u. a. zum Erkennen eines Doppelerdschlusses ein anderes oder zumindest weiteres Kriterium vorgeschlagen, das von dem Erdstrom unabhängig ist. Konkret sieht die Erfindung vor, zumindest auch die verketteten Phasenspannungen zum Erkennen eines Fehlers heranzuziehen und ein entsprechendes Symmetriesignal zu bilden. Dieses Symmetriesignal ermöglicht es beispielsweise, selbst bei sehr weit entfernten Kurzschlussstellen bei Doppelerdschlüssen mit nur geringem Erdstrom einen Doppelerdschluss zuverlässig zu erkennen. Außerdem kann - wie weiter unten erläutert werden wird - das Symmetriesignal für andere Zwecke verwendet werden, beispielsweise zum Blockieren eines Fehlersignals bei Einfach-Erdschlusswischern (kurzzeitige Einfach-Erdschlüsse).

Besonders bevorzugt wird zusätzlich überprüft, ob die Nullspannung des Energieübertragungsnetzes einen vorgegebenen Nullspannungs-Schwellenwert überschreitet. Ist dies der Fall und überschreiten die verketteten Phasenspannungen des Energieübertragungsnetzes relativ zueinander die vorgegebene amplitudenbezogene Unsymmetrie-Schwelle, so wird ein Anregesignal erzeugt, das auf die Möglichkeit bzw. die hohe Wahrscheinlichkeit hinweist, dass ein Erdfehler vorliegt. Das Anregesignal kann beispielsweise als Triggersignal für weitere Untersuchungen herangezogen werden.

Vorzugsweise wird zusätzlich auch der Nullstrom gemessen und das Anregesignal zusätzlich auch dann erzeugt, wenn der Nullstrom einen vorgegebenen Nullstrom-Schwellenwert überschreitet.

Besonders einfach und damit vorteilhaft lässt sich eine Unsymmetrie der verketteten Spannungen feststellen, indem die Amplituden der drei verketteten Phasenspannungen bestimmt werden und indem die vorgegebene amplitudenbezogene Unsymmetrie-Schwelle als überschritten angesehen wird, wenn die Differenz zwischen der größten Amplitude und der kleinsten Amplitude eine vorgegebene Differenzschwelle überschreitet.

Gemäß einer bevorzugten Ausgestaltung des Verfahrens ist vorgesehen, dass geprüft wird, ob eine Stromwandlersättigung bezüglich zumindest eines Phasenleiterstrommesswerts aufgetreten ist, und dass im Falle einer Stromwandlersättigung das Erzeugen des Anregesignals unterdrückt wird, sofern ausschließlich das Überschreiten des Nullstrom-Schwellenwerts durch den Nullstrom das Anregesignal auslösen würde.

Im Hinblick auf eine Anpassung des heranzuziehenden Schwellenwerts an die im Einzelfall vorliegende Belastung der Leitung wird es als vorteilhaft angesehen, wenn der vorgegebene Nullstrom-Schwellenwert eine variable Größe ist, die in Abhängigkeit von den Strommesswerten adaptiv verändert wird. Vorzugsweise wird der vorgegebene Nullstrom-Schwellenwert umso größer eingestellt, je größer die Strommesswerte sind. Beispielsweise kann der vorgegebene Nullstrom-Schwellenwert durch eine mathematische Funktion definiert werden, bei der die gemessenen Strommesswerte Parameter sind.

Um im Falle eines Doppelerdschlusses die erforderlichen Abhilfemaßnahmen einleiten zu können, wird es als vorteilhaft angesehen, wenn die beiden vom Doppelerdschluss betroffenen fehlerbehafteten Phasenleiter ermittelt werden und ein die beiden Phasenleiter kennzeichnendes Fehlersignal erzeugt wird.

Wenn die Nullspannung den vorgegebenen Nullspannungs-Schwellenwert überschreitet und wenn außerdem die verketteten Phasenspannungen zueinander die vorgegebene Unsymmetrie-Schwelle überschreiten, werden die beiden fehlerbehafteten Phasenleiter vorzugsweise sofort ermittelt und das entsprechende Fehlersignal wird sofort erzeugt.

Vorzugsweise wird das Fehlersignal für einen Doppelerdschluss erzeugt, indem die Amplituden der verketteten Spannungen und die Amplituden der einzelnen Phasenleiter-Erde-Spannungen ermittelt werden, wobei zwei der drei Phasenleiter als fehlerbehaftet identifiziert werden, wenn die Amplitude ihrer verketteten Spannung die kleinste der drei ermittelten Amplituden der verketteten Spannungen bildet und wenn außerdem die Amplitude ihrer Phasenleiter-Erde-Spannungen kleiner als die des dritten fehlerfreien Phasenleiters ist.

Wenn die Nullspannung den vorgegebenen Nullspannungs-Schwellenwert unterschreitet oder die verketteten Phasenspannungen zueinander die vorgegebene Unsymmetrie-Schwelle unterschreiten, wird das Fehlersignal für einen Doppelerdschluss vorzugsweise dann erzeugt, wenn zwei Leiter-Erde-Schleifenimpedanzen innerhalb und eine außerhalb eines vorgegebenen Anregebereichs liegen.

Im Übrigen kann im Rahmen des Verfahrens auch geprüft werden, ob ein Einphasen-Erdschluss vorliegt, und es kann im Falle eines detektierten Einphasen-Erdschlusses ein entsprechendes Fehlersignal für einen Einphasen-Erdschluss erzeugt werden.

Wenn ein Einphasen-Erdschluss detektiert wird, wird bevorzugt für eine vorgegebene Zeitdauer zunächst ein Sperrsignal erzeugt, das eine Ausgabe des Fehlersignals für diese Zeitdauer blockiert. Durch eine solche Vorgehensweise wird in vorteilhafter Weise verhindert, dass kurzzeitige "Erdschlusswischer" (also kurze Erdschlüsse) ein Abschalten von Leitungen oder sonstiges Reaktionen außerhalb des Schutzgerätes auslösen können. Zu einer solchen Blockierung kommt es jedoch nur dann, wenn die verketteten Phasenspannungen die Unsymmetrie-Schwelle unterschreiten bzw. das entsprechende Symmetriesignal eine Symmetrie der verketteten Phasenspannungen anzeigt.

Das Erzeugen eines Sperrsignals und das Blockieren des Fehlersignals für einen Einphasen-Erdschluss wird im Übrigen als selbstständige Erfindung angesehen, unabhängig davon, ob oder wie Anregesignale oder Fehlersignale für einen Doppelerdschluss erzeugt werden. Eine selbstständige Erfindung bildet somit auch ein Verfahren zum Erzeugen eines Fehlersignals für einen Einphasen-Erdschluss, bei dem nach Detektion des Einphasen-Erdschlusses für eine vorgegebene Zeitdauer zunächst ein Sperrsignal erzeugt wird, das eine Ausgabe des Fehlersignals für diese Zeitdauer blockiert. Zu einer solchen Blockierung kommt es jedoch nur dann, wenn die verketteten Phasenspannungen eine vorgegebene Unsymmetrie-Schwelle unterschreiten bzw. ein entsprechendes Symmetriesignal eine Symmetrie der verketteten Phasenspannungen anzeigt. Beispielsweise wird bei einem solchen Verfahren ein Zeitglied eingesetzt.

Im Übrigen wird es als vorteilhaft angesehen, wenn bei Vorliegen des Fehlersignals für einen Doppelerdschluss, bei dem ein erster Erdschluss auf einer ersten dreiphasigen Leitung und ein zweiter Erdschluss auf einer mit der ersten Leitung verbundenen zweiten dreiphasigen Leitung aufgetreten ist, von den betroffenen Leitungen diejenige abgeschaltet wird, deren vom Fehler betroffener Phasenleiter gemäß einer vorgegebenen Phasenleiter-Vorzugsliste bevorzugt abzuschalten ist, und dass die andere Leitung zumindest zunächst unabgeschaltet bleibt.

Die Erfindung bezieht sich außerdem auf ein Schutzgerät mit einer Prüfeinrichtung zum Überwachen eines gelöschten oder gegenüber Erdpotential isolierten dreiphasigen Energieübertragungsnetzes im Hinblick auf das Vorliegen eines Erdschlusses.

Der Erfindung liegt bezüglich eines solchen Schutzgerätes die Aufgabe zugrunde, dieses dahingehend zu verbessern, dass es im Falle eines Doppelerdschlusses auch bei räumlich weit auseinander liegenden Kurzschlussstellen zuverlässig arbeitet.

Diese Aufgabe wird erfindungsgemäß dadurch gelöst, dass die Prüfeinrichtung eine Symmetrie-Prüfeinrichtung umfasst, die derart ausgestaltet ist, dass sie überprüft, ob die verketteten Phasenspannungen des Energieübertragungsnetzes relativ zueinander eine vorgegebene amplitudenbezogene Unsymmetrie-Schwelle überschreiten, dass sie ein entsprechendes Symmetriesignal bildet, das eine Symmetrie oder Unsymmetrie der verketteten Phasenspannungen anzeigt, und dass sie dieses Symmetriesignal bei der weiteren Überwachung heranzieht.

Bezüglich der Vorteile des erfindungsgemäßen Schutzgerätes sowie hinsichtlich vorteilhafter Ausgestaltungen des Schutzgerätes sei auf die obigen Ausführungen im Zusammenhang mit dem erfindungsgemäßen Verfahren verwiesen.

Die Erfindung bezieht sich außerdem auf ein Verfahren zum Betreiben einer Anordnung mit zwei Schutzgeräten, die an unterschiedliche Leitungen eines Energieübertragungsnetzes angeschlossen sind.

Diesbezüglich ist erfindungsgemäß vorgesehen, dass jedes der zwei Schutzgeräte seine zugeordnete Leitung auf das Vorliegen eines Doppelerdschlusses überwacht und im Falle, dass eine vom Doppelerdschluss betroffene Phase zu einer der beiden Leitungen und die andere vom Doppelerdschluss betroffene Phase zu der anderen Leitung gehört, dasjenige der zwei Schutzgeräte seine zugeordnete Leitung abschaltet, zudem die bevorzugt abzuschaltende fehlerbehaftete Phase gemäß einer den beiden Schutzgeräten vorgegebenen Phasenabschaltreihenfolge gehört.

Die Erfindung wird nachfolgend anhand von Ausführungsbeispielen näher erläutert; dabei zeigen beispielhaft:

Figur 1    ein Ausführungsbeispiel für ein erfindungsgemäßes Schutzgerät;

Figur 2    ein Ausführungsbeispiel für eine Prüfeinrichtung des Schutzgeräts gemäß Figur 1;

Figur 3    ein Ausführungsbeispiel für eine Symmetrie-Prüfeinrichtung der Prüfeinrichtung gemäß Figur 2;

Figur 4    ein Ausführungsbeispiel für eine Fehlersignal-Erzeugungseinrichtung des Schutzgeräts gemäß Figur 1;

Figur 5    ein Ausführungsbeispiel für eine Spannungszei- ger-Auswerteinrichtung der Fehlersignal-Erzeu- gungseinrichtung gemäß Figur 4;

Figur 6    ein Ausführungsbeispiel für eine Schleifenimpedanz-Auswerteinrichtung der Feh- lersignal-Erzeugungseinrichtung gemäß Figur 4;

Figur 7    beispielhaft einen Impedanz-Anregebereich in der komplexen Ebene;

Figur 8    beispielhaft, wie Leiter-Erde-Spannungszeiger und verkettete Spannungszeiger im fehlerfreien Zustand, im Falle eines Einfach-Erdschlusses (z. B. Phasenleiter L2 betroffen) oder im Falle eines Doppelerdschlusses (z. B. Phasen- leiter L1 und L2 betroffen) aussehen können; und

Figur 9    beispielhaft eine Anordnung mit zwei Schutzgeräten und deren Betrieb.

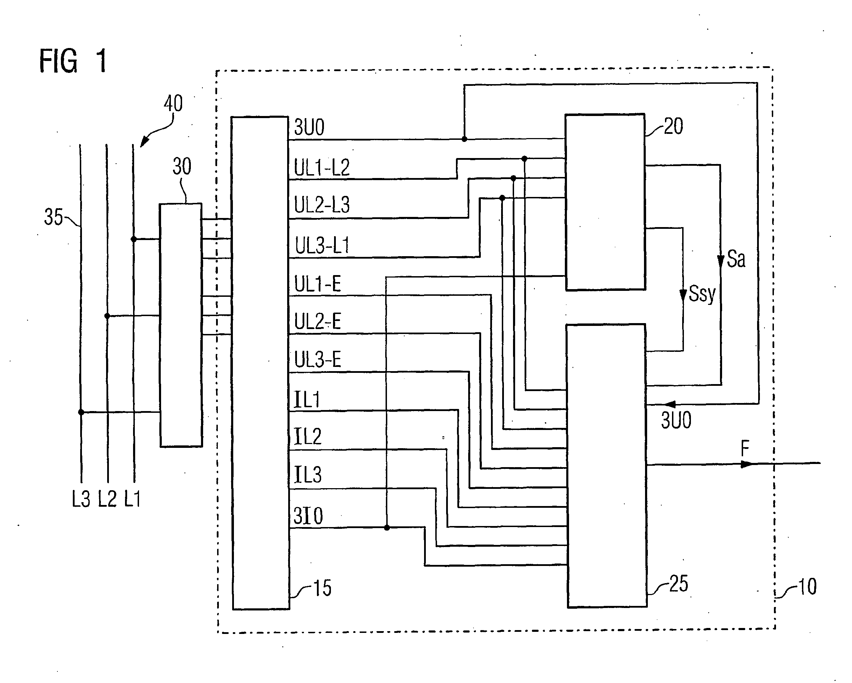

In der Figur 1 ist ein Ausführungsbeispiel für ein erfindungsgemäßes Schutzgerät 10 dargestellt. Das Schutzgerät 10 weist zur Erkennung eines Doppelerdschlusses eingansseitig eine Umrechnungseinrichtung 15 auf, die mit einer Prüfeinrichtung 20 sowie mit einer Fehlersignal-Erzeugungseinrichtung 25 in Verbindung steht. Die Umrechnungseinrichtung 15 ist über eine externe Wandlereinheit 30 mit einer Energieübertragungsleitung 35 eines gelöschten oder gegenüber Erdpotential isolierten dreiphasigen Energieübertragungsnetzes 40 verbunden.

Die Wandlereinheit 30 misst die in der Energieübertragungsleitung 35 fließenden Ströme sowie die entsprechenden Leitererdespannungen der Phasenleiter der Energieübertragungsleitung 35 und erzeugt ausgangsseitig entsprechende Messgrößen, die zur Umrechnungseinrichtung 15 gelangen und von dieser weiterverarbeitet werden. Die Umrechnungseinrichtung 15 erzeugt mit den von der Wandlereinheit 30 gebildeten Messgrößen ausgangsseitig Spannungs- und Strommesswerte, und zwar Leitererdespannungsmesswerte UL1-E, UL2-E und UL3-E sowie verkettete Spannungen UL1-L2, UL2-L3 und UL3-L1 und Phasenstrommesswerte IL1, IL2 und IL3. Außerdem erzeugt die Wandlereinheit 30 einen Messwert für die Nullspannung 3U0 der Energieübertragungsleitung 35 sowie einen Messwert für den Nullstrom 3I0. Die Messwerte für den Nullstrom, die Nullspannung sowie die verketteten Spannungen werden wie folgt gebildet:

$$\underline{3U0} = \underline{UL1-E} + \underline{UL2-E} + \underline{UL3-E}$$

$$\underline{3I0} = \underline{IL1} + \underline{IL2} + \underline{IL3}$$

$$\underline{UL1-L2} = \underline{UL1-E} - \underline{UL2-E}$$

$$\underline{UL3-L2} = \underline{UL3-E} - \underline{UL2-E}$$

$$\underline{UL1-L3} = \underline{UL1-E} - \underline{UL3-E}$$

$\underline{IL1}$, $\underline{IL2}$, $\underline{IL3}$, $\underline{UL1-L2}$, $\underline{UL2-L3}$, $\underline{UL3-L1}$, $\underline{UL1-E}$, $\underline{UL2-E}$, $\underline{UL3-E}$ bezeichnen die Messwerte in komplexer Zeigerform.

Die entsprechenden Messwerte gelangen - wie in der Figur 1 gezeigt - zu der Prüfeinrichtung 20 und zu der Fehlersignal-Erzeugungseinrichtung 25. Die Aufgabe der Prüfeinrichtung 20 besteht darin, mit den eingangsseitig anliegenden Messwerten ein Anregesignal Sa sowie ein Symmetriesignal Ssy zu erzeugen.

Das Anregesignal Sa gibt an, dass in dem Energieübertragungsnetz 40 womöglich ein Erdschluss aufgetreten ist. Das Symmetriesignal Ssy zeigt an, dass die verketteten Phasenspannungen UL1-L2, UL2-L3 und UL3-L1 symmetrisch oder unsymmetrisch zueinander sind. Von einer Unsymmetrie wird ausgegangen, wenn die verketteten Phasenspannungen UL1-L2, UL2-L3 und UL3-L1 relativ zueinander eine vorgegebene amplitudenbezogene Unsymmetrieschwelle überschreiten.

Die ausgangsseitig von der Prüfeinrichtung 20 erzeugten Signale, nämlich das Anregesignal Sa sowie das Symmetriesignal Ssy, gelangen zu der Fehlersignal-Erzeugungseinrichtung 25, die diese Signale weiterverarbeitet. Die Funktion der Fehlersignal-Erzeugungseinrichtung 25 besteht darin, im Falle eines Erdschlusses zu ermitteln, welche der Phasenleiter der Energieübertragungsleitung 35 bzw. des Energieübertragungsnetzes 40 von dem Erdschluss betroffen sind, und ausgangsseitig ein entsprechendes Fehlersignal F zu erzeugen, das die entsprechenden Phasenleiter identifiziert.

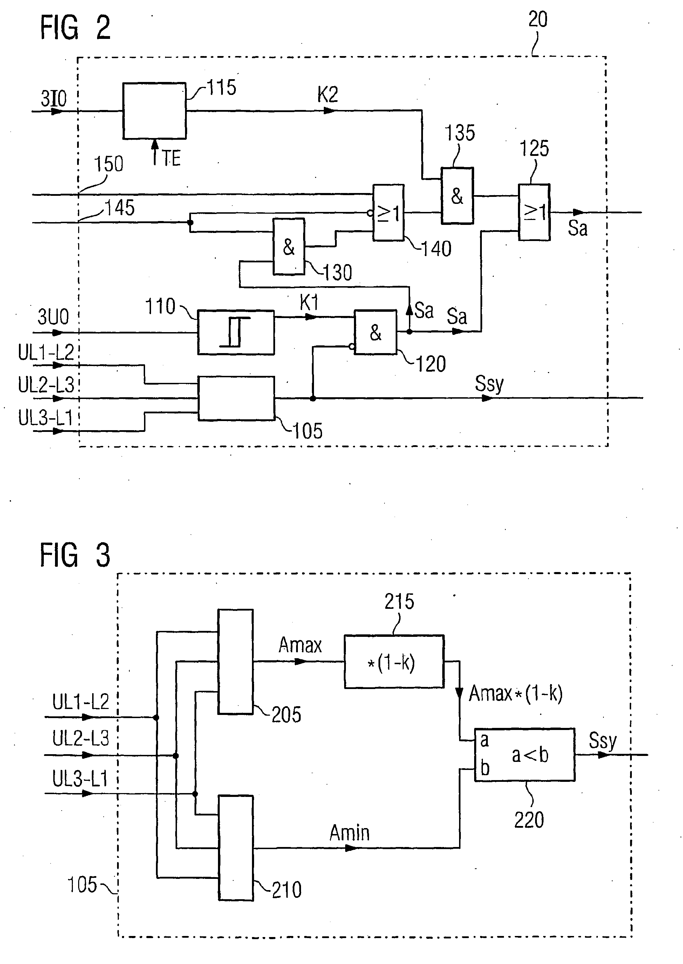

In der Figur 2 ist ein Ausführungsbeispiel für die Prüfeinrichtung 20 gemäß Figur 1 dargestellt. Man erkennt eingangsseitig eine Symmetrie-Prüfeinrichtung 105, an der eingangsseitig die verketteten Spannungen UL1-L2, UL2-L3 und UL3-L1 anliegen. Die Symmetrie-Prüfeinrichtung 105 prüft, ob die eingangsseitig anliegenden verketteten Phasenspannungen symmetrisch zueinander sind und erzeugt ausgangsseitig im Falle einer Symmetrie das Symmetriesignal Ssy mit einer logischen 1 und im Falle einer Unsymmetrie mit einer logischen 0.

Die Prüfeinrichtung 20 ist darüber hinaus mit einem Nullspannungskomparator 110 ausgestattet, der die anliegende Nullspannung 3U0 mit einem vorgegebenen Nullspannungsschwellenwert vergleicht und ausgangsseitig ein Vergleichssignal K1 erzeugt, wenn die Amplitude der eingangsseitig anliegenden Nullspannung den vorgegebenen Nullspannungsschwellenwert überschreitet. Weist das Vergleichssignal K1 eine logische 1 auf und sind die verketteten Phasenspannungen außerdem unsymmetrisch zueinander (Ssy = "0"), so erzeugt das UND-Glied 120, an dessen invertierendem Eingang das Symmetriesignal Ssy anliegt, ausgangsseitig eine logische 1, die von dem ODER-Glied 125 als Anregesignal Sa weitergeleitet wird.

Die Prüfeinrichtung 20 ist darüber hinaus mit einer Nullstrom-Überwachungseinrichtung 115 ausgestattet, die den eingangsseitig anliegenden Nullstrom mit einem einstellbaren Nullstrom-Schwellenwert vergleicht. Überschreitet der eingangsseitig anliegende Nullstrom 3I0 diesen Schwellenwert, so wird ausgangsseitig ein zweites Vergleichssignal K2 mit einer logischen "1" erzeugt. Die Nullstrom-Überwachungseinrichtung 115 kann über ein Stellsignal TE von außen eingestellt werden, beispielsweise in Abhängigkeit von der Größe der in den Phasenleitern der Energieübertragungsleitung 35 fließenden Phasenströme.

In der Figur 2 erkennt man außerdem ein UND-Glied 120 sowie ein ODER-Glied 125, die hintereinander geschaltet sind und eingangsseitig mit der Symmetrie-Prüfeinrichtung 105 sowie dem Nullspannungskomparator 110 in Verbindung stehen. Das ODER-Glied 125 gibt ausgangsseitig das Anregesignal Sa mit einer logischen 1 ab, sofern der Nullspannungskomparator 110 feststellt, dass die eingangsseitig anliegende Nullspannung 3U0 den vorgegebenen Nullspannungsschwellenwert überschreitet, und sofern zusätzlich die Symmetrie-Prüfeinrichtung 105 feststellt, dass die eingangsseitig anliegenden verketteten Phasenspannungen unsymmetrisch zueinander sind.

Wird von dem UND-Glied 120 ausgangsseitig eine logische 0 erzeugt, so kann das ODER-Glied 125 ausgangsseitig trotzdem eine logische 1 als Anregesignal Sa abgeben, wenn die Nullstrom-Überwachungseinrichtung 115 feststellt, dass der Nullstrom 3I0 den vorgegebenen Nullstrom-Schwellenwert überschreitet und das entsprechende zweite Vergleichssignal K2 mit einer logischen 1 erzeugt.

In der Figur 2 erkennt man außerdem weitere UND-Glieder 130 und 135 sowie ein zusätzliches ODER-Glied 140. Die Funktion dieser drei Komponenten besteht darin, die Abgabe des zweiten Vergleichssignals K2 der Nullstrom-Überwachungseinrichtung 115 als Anregesignal Sa zu blockieren. Liegt nämlich an einem Stromwandler-Sättigungseingang 145 der Prüfeinrichtung 20 ein Signal mit einer logischen 1 an, das auf eine Stromwandlersättigung hindeutet, so lässt sich über das weitere UND-Glied 130, das ODER-Glied 140, an dessen invertierenden Eingang das Signal vom Stromwandler-Sättigungseingang 145 geleitet wird, sowie das weitere UND-Glied 135 verhindern, dass bei Vorliegen einer logischen 1 beim zweiten Vergleichssignal K2 ausgangsseitig ein Anregesignal Sa mit einer logischen 1 erzeugt wird.

Die Verschaltung der beiden UND-Glieder 130 und 135 sowie des ODER-Glieds 140 ermöglicht es darüber hinaus, den Stromwandler-Sättigungseingang 145 zu deaktivieren, indem an einem entsprechenden Eingang 150 der Prüfeinrichtung 20 ein Signal mit einer logischen 1 angelegt wird. Liegt nämlich am Eingang 150 eine logische 1 an, so wird der Ausgang des weiteren ODER-Gliedes 140 stets eine logische 1 aufweisen, so dass eine eventuell von der Nullstrom-Überwachungseinrichtung 115 erzeugte logische 1 im zweiten Vergleichssignal K2 stets an den Ausgang des ODER-Gliedes 125 durchgeschaltet wird, wodurch am Ausgang der Prüfeinrichtung 20 das Anregesignal Sa mit einer logischen 1 erzeugt wird.

In der Figur 3 ist ein Ausführungsbeispiel für die Symmetrie-Prüfeinrichtung 105 der Prüfeinrichtung 20 gemäß Figur 2 dargestellt. Man erkennt, dass die Symmetrie-Prüfeinrichtung 105 eingangsseitig zwei Vergleichsbausteine 205 und 210 aufweist. Bei dem Vergleichsbaustein 205 handelt es sich um einen Baustein, der die maximalen Amplituden der drei verketteten Phasenspannungen, die eingangsseitig an der Symmetrie-Prüfeinrichtung 105 anliegen, bestimmt und ausgangsseitig einen Maximalamplitudenwert Amax erzeugt, der die Amplitudenhöhe derjenigen Amplitude angibt, die von den drei verketteten Phasenspannungen die größte ist.

In entsprechender Weise arbeitet der Vergleichsbaustein 210, der jedoch von den drei eingangsseitig anliegenden verketteten Phasenspannungen diejenige Amplitude bestimmt, die am kleinsten ist. Ausgangsseitig erzeugt der Vergleichsbaustein 210 einen Wert Amin für die minimale Amplitude.

Dem Vergleichsbaustein 205 nachgeordnet ist eine Multipliziereinrichtung 215, die den Wert Amax für die maximale Amplitude mit einem Korrekturfaktor (1-k) multipliziert. K beträgt beispielsweise 2 %, so dass also der Wert für die maximale Amplitude Amax in diesem Beispielfall mit einem Wert von 0,98 multipliziert wird.

Der Ausgangswert der Multipliziereinrichtung 215 sowie der Wert Amin für die minimale Amplitude gelangen zu einem Komparator 220, der die beiden eingangsseitig anliegenden Werte miteinander vergleicht und ausgangsseitig das Symmetriesignal Ssy mit einer logischen 1 erzeugt, wenn der Wert Amax*(1-k) kleiner ist als der Wert Amin für die Minimalamplitude, was bedeutet, dass die maximale Amplitude und die minimale Amplitude relativ ähnlich sind und somit eine "Symmetrie" der verketteten Leiter-Erde-Spannungen vorliegt. In entsprechender Weise erzeugt der Komparator 220 das Symmetriesignal Ssy mit einer logischen 0 dann, wenn das Produkt Amax*(1-k) den Wert Amin für die minimale Amplitude überschreitet: Überschreitet nämlich das Produkt Amax*(1-k) den Wert Amin, so bedeutet dies anschaulich, dass die maximale Amplitude Amax sehr viel größer (zumindest mehr als 2% größer) ist als die minimale Amplitude Amin und somit eine "Unsymmetrie" der verketteten Leiter-Erde-Spannungen vorliegt.

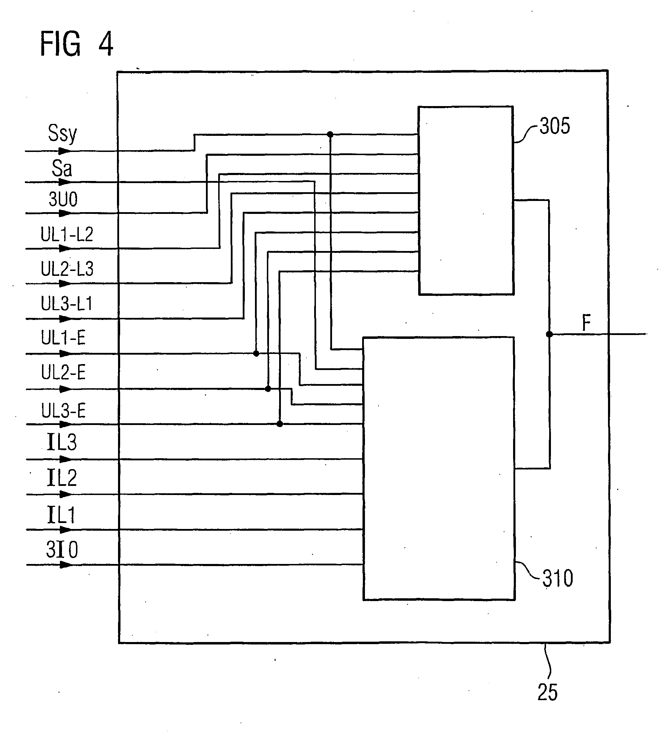

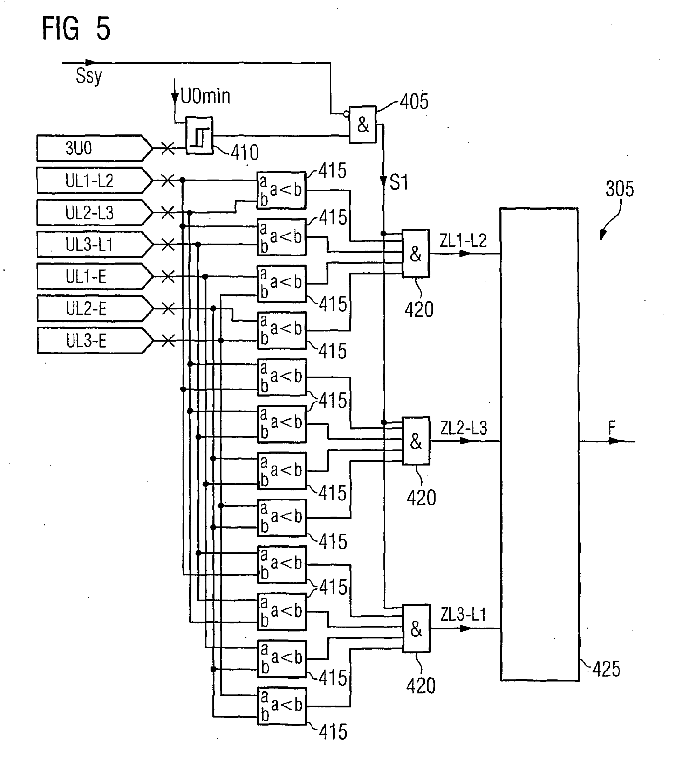

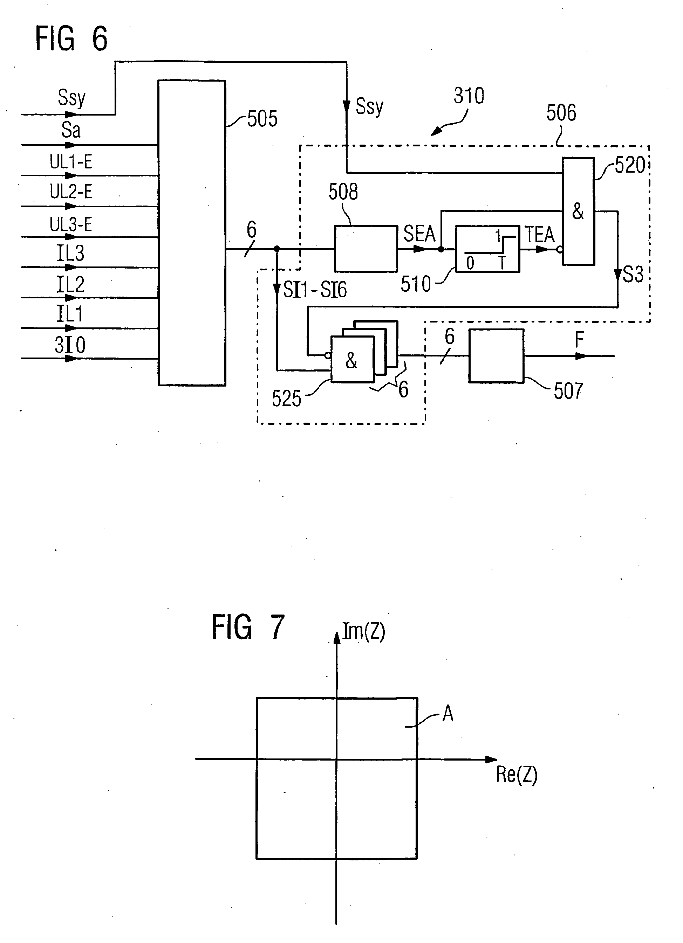

In der Figur 4 ist ein Ausführungsbeispiel für die Fehlersignal-Erzeugungseinrichtung 25 gemäß Figur 1 dargestellt. Man erkennt, dass die Fehlersignal-Erzeugungseinrichtung eine Spannungszeiger-Auswerteinrichtung 305 sowie eine Schleifenimpedanz-Auswerteinrichtung 310 aufweist. Die Spannungszeiger-Auswerteinrichtung 305 sowie die Schleifenimpedanz-Auswerteinrichtung 310 sind jeweils eingangsseitig mit dem Symmetriesignal Ssy der Prüfeinrichtung 20 beaufschlagt und arbeiten parallel. Die Aktivierung der beiden Einrichtungen 305 und 310 wird näher im Zusammenhang mit den Figuren 5 und 6 erläutert.

In der Figur 5 ist ein Ausführungsbeispiel für die Spannungszeiger-Auswerteinrichtung 305 gemäß Figur 4 dargestellt. Man erkennt ein UND-Glied 405, das eingangsseitig mit dem Symmetriesignal Ssy beaufschlagt ist. Das UND-Glied 405 erzeugt ausgangsseitig eine logische 1, wenn das Symmetriessignal Ssy eine logische 0 aufweist und wenn gleichzeitig die Nullspannung 3U0 den vorgegebenen Nullspannungsschwellwert U0min überschreitet; letzteres wird durch einen Komparator 410 festgestellt.

Bei dem Ausführungsbeispiel gemäß Figur 5 bilden das UND-Glied 405 sowie der Komparator 410 Bestandteile der Spannungszeiger-Auswerteinrichtung 305, um ein Aktivierungssignal S1 für die Spannungszeiger-Auswerteinrichtung 305 zu bilden. Im Hinblick auf eine minimale Teilezahl innerhalb des Schutzgerätes 10 können diese beiden Komponenten, also das UND-Glied 405 sowie der Komparator 410 auch weggelassen werden und es kann stattdessen das Ausgangssignal des UND-Gliedes 120 der Prüfeinrichtung 20 gemäß Figur 2 verwendet und als Aktivierungssignal S1 in die Spannungszeiger-Auswerteinrichtung 305 eingespeist werden.

Das Aktivierungssignal S1 entspricht im Übrigen dem Anregesignal Sa gemäß der Figur 2 für den Fall einer Unsymmetrie der verketteten Phasenspannungen. Das Aktivierungssignal S1 gemäß der Figur 5 sowie das Ausgangssignal des UND-Gliedes 120 bilden somit selbständig bzw. auch allein Anregesignale im Sinne der obigen Erläuterungen zu vorteilhaften Ausgestaltungen der Erfindung.

Wie sich in der Figur 5 darüber hinaus erkennen lässt, weist die Spannungszeiger-Auswerteinrichtung 305 insgesamt zwölf Komparatoren 415 auf, die in der in der Figur 5 dargestellten Weise mit den verketteten Phasenspannungen-UL1-L2, UL2-L3 und UL3-L1 sowie den Leitererdespannungen UL1-E, UL2-E und UL3-E beaufschlagt sind. Je nach dem, wie die Spannungsverhältnisse am Eingang der Spannungszeiger-Auswerteinrichtung 305 konkret aussehen, gelangen entsprechende Auswertsignale zu insgesamt drei nachgeschalteten UND-Gliedern 420, die jeweils mit insgesamt vier der Komparatoren 415 verbunden sind. Die Ausgangssignale ZL1-L2, ZL2-L3 und ZL3-L1 geben durch eine logische 1 an, das sie einen bestimmten Fehlerzustand erkannt haben:

Weist das Ausgangssignal ZL1-L2 eine logische 1 auf, so sind die beiden Phasenleiter L1 und L2 des Energieversorgungsnetzes von einem Doppelerdschluss betroffen. Weist das Ausgangssignal ZL2-L3 eine logische 1 auf, so sind die beiden Phasenleiter L2 und L3 des Energieversorgungsnetzes von einem Doppelerdschluss betroffen; weist das Ausgangssignal ZL3-L1 eine logische 1 auf, so sind die beiden Phasenleiter L1 und L3 des Energieversorgungsnetzes von einem Doppelerdschluss betroffen.

Die Ausgangssignale ZL1-L2, ZL2-L3 und ZL3-L1 der nachgeschalteten UND-Glieder 420 gelangen zu einer Kodiereinrichtung 425, die die binären Ausgangssignale ZL1-L2, ZL2-L3 und ZL3-L1 zu dem digitalen Fehlersignal F umkodiert.

Zu einer Erzeugung des Fehlersignals F durch die Kodiereinrichtung 425 kann es dabei nur kommen, wenn durch das UND-Glied 405 bzw. durch das UND-Glied 120 gemäß Figur 2 das entsprechende Aktivierungssignal S1 mit einer logischen 1 für die drei UND-Glieder 420 erzeugt wird.

Anschaulich beschrieben funktioniert die Spannungszeiger-Auswerteinrichtung 305 derart, dass das Fehlersignal F anzeigt, welche der Phasenleiter L1, L2 bzw. L3 des Energieübertragungsnetzes 40 von dem Doppelerdschluss betroffen sind. Als fehlerbehaftete Phasenleiter erkennt die Spannungszeiger-Auswerteinrichtung 305 dabei diejenigen Phasenleiter, deren verkettete Spannung die kleinste Amplitude im Vergleich zu den beiden übrigen verketteten Spannungen aufweist und deren Phasenleiter-Erdespannungen amplitudenmäßig kleiner als die des nicht betroffenen Phasenleiters sind.

In der Figur 6 ist ein Ausführungsbeispiel für die Schleifenimpedanz-Auswerteinrichtung 310 gemäß Figur 4 dargestellt. Man erkennt eine Impedanz-Anregungseinrichtung 505, die eingangsseitig mit den Strom- und Spannungswerten der Umrechnungseinrichtung 15 gemäß Figur 1 beaufschlagt ist. Sofern am Eingang der Impedanz-Anregungseinrichtung 505 das Anregesignal Sa mit einer logischen 1 vorliegt, wertet die Impedanz-Anregungseinrichtung 505 die eingangsseitig anliegenden Strom- und Spannungswerte aus und erzeugt auf sechs signalindividuellen Leitungen (von denen in der Figur 6 der Übersichtlichkeit nur eine dargestellt ist) ausgangsseitig für jede angeregte Leiter-Erde-Schleife und jede angeregte Leiter-Leiter-Schleife ein binäres Signal SI1, SI2, ..., SI6 (z. B. SI1-SI3 für Leiter-Erde-Schleifen und SI4-SI6 für Leiter-Leiter-Schleifen) mit einer logischen 1 und für jede nichtangeregte Schleife ein entsprechendes Signal mit einer logischen 0. Unter einer angeregten Schleife ist in diesem Zusammenhang eine solche zu verstehen, bei der die Schleifenimpedanz innerhalb eines entsprechenden Impedanz-Anregebereichs A liegt. Die Figur 7 zeigt einen solchen Impedanz-Anregebereich beispielhaft in der komplexen Ebene.

Sofern am Eingang der Impedanz-Anregungseinrichtung 505 das Anregesignal Sa mit einer logischen 0 vorliegt, wertet die Impedanz-Anregungseinrichtung 505 die eingangsseitig anliegenden Strom- und Spannungswerte bezüglich des Vorliegens eines Erdschlusses hingegen nicht aus und erzeugt ausgangsseitig auch keine binären Signale SI1, SI2 oder SI3 bzw. nur solche mit einer logischen 0. Die Leiter-Leiter-Impedanzen werden unabhängig vom Anregesignal Sa beobachtet und ausgewertet.

Mit der Impedanz-Anregungseinrichtung 505 steht ausgangsseitig eine Einfach-Erdschlusswischer-Blockiereinrichtung 506 in Verbindung, der eine Impedanzsignal-Auswerteeinrichtung 507 nachgeordnet ist. Die Einfach-Erdschlusswischer-Blockiereinrichtung 506 weist u. a. eine eine Einphasen-Anregung erkennende Einrichtung 508, ein der Einrichtung 508 nachgeordnetes Zeitglied 510 sowie ein UND-Glied 520 auf.

Die eine Einphasen-Anregung erkennende Einrichtung 508 wertet die von der Impedanz-Anregungseinrichtung 505 gelieferten Signale SI1-SI6 aus und erzeugt ausgangsseitig ein binäres Signal SEA mit einer logischen 1, wenn keine der drei Leiter-Leiter-Schleifen (SI4 = SI5 = SI6 =0) angeregt ist und wenn von den drei Leiter-Erde-Schleifen genau eine einzige angeregt ist; eine solche Signalkonstellation deutet nämlich auf einen Einfach-Erdschluss hin. In allen anderen Fällen erzeugt die eine Einphasen-Anregung erkennende Einrichtung 508 ein Signal SEA mit einer logischen 0.

Wenn das Signal SEA von einer logischen 0 auf eine logische 1 übergeht, so erzeugt das Zeitglied 510 um eine Zeitdauer T von beispielsweise zwei Periodenlängen verzögert - bezogen auf die Nennfrequenz des Energieübertragungsnetzes 40 - ein entsprechendes Rechtecksignal TEA. Das Signal TEA weist eine logische 1 für eine vorgegebene Einschaltdauer Tein und eine logische 0 für den Zeitraum davor und danach auf und wird an das UND-Glied 520 weitergeleitet. Nach einer erfolgten Aktivierung des Zeitgliedes kann dieses für eine vorgegebene Zeitspanne T+Tein nicht erneut aktiviert werden; erst nach Ablauf der Spanne T+Tein ist ein Neustart möglich.

An dem UND-Glied 520 liegen somit das Symmetriesignal Ssy der Prüfeinrichtung 20, das Ausgangssignal SEA der Einrichtung 508 sowie das Rechtecksignal TEA an.

Das UND-Glied 520 erzeugt ausgangsseitig ein Sperrsignal S3 mit einer logischen 1 für ein nachgeordnetes UND-Glied 525, wenn das Symmetriesignal Ssy und das Ausgangssignal SEA eine logische 1 und das Rechtecksignal TEA eine logische 0 aufweisen. In diesem Falle, wenn also das Sperrsignal S3 eine logische 1 aufweist, wird das UND-Glied 525 gesperrt, so dass zur Impedanzsignal-Auswerteeinrichtung 507 keine Signale SI1, SI2, ..., SI6 gelangen können und diese auch kein Fehlersignal F erzeugt; es liegt also eine Blockierung vor.

Das UND-Glied 520 erzeugt hingegen ausgangsseitig ein Sperrsignal S3 mit einer logischen 0 für das nachgeordnete UND-Glied 525, wenn das Symmetriesignal Ssy oder das Ausgangssignal SEA eine logische 0 oder das Rechtecksignal TEA eine logische 1 aufweisen. In diesem Falle wird das UND-Glied 525 durchgeschaltet, so dass zur Impedanzsignal-Auswerteeinrichtung 507 alle Signale, SI1, SI2, ..., SI6 gelangen können und die Impedanzsignal-Auswerteeinrichtung 507 das Fehlersignal F erzeugen kann.

Ist das UND-Glied 525 durchgeschaltet, erzeugt die Impedanzsignal-Auswerteeinrichtung 507 ein einen Doppelerdschluss kennzeichnendes Fehlersignal, wenn zwei Leiter-Erdeschleifen angeregt sind und die entsprechenden zwei Signale SI1 und SI2 bzw. SI2 und SI3 bzw. SI3 und SI1 eine logische 1 aufweisen; das Fehlersignal F kennzeichnet in diesem Falle die beiden Phasenleiter, deren Leiter-Erdeschleifen einen Doppelerdschluss aufweisen. Weist nur eine Leiter-Erdeschleife einen Kurzschluss auf, so kann dementsprechend ein Fehlersignal für einen Einfach-Erdschluss erzeugt werden, wobei das Fehlersignal den betreffenden Phasenleiter bezeichnet. Die Impedanzsignal-Auswerteeinrichtung 507 ist darüber hinaus in der Lage, Leiter-Leiter-Kurzschlüsse zu erkennen und ein entsprechendes Feh-

lersignal F zu erzeugen, wenn eine Leiter-Leiterschleife angeregt ist und das entsprechende Signal SI4, SI5 oder SI6 eine logische 1 aufweist.

Die Aufgabe der beschriebenen Einfach-Erdschlusswischer-Blockiereinrichtung 506 besteht im Falle eines Einfach-Erdschlusses darin, das Weiterleiten der Signale SI1, SI2 und SI3 zu blockieren, wenn nur kurzzeitige Einfach-Erdschlüsse - sogenannte Erdschlusswischer - auftreten. Im Falle eines Einfach-Erdschlusses bleibt nämlich aufgrund des Zeitgliedes 510 das UND-Glied 525 für die Zeitspanne T blockiert, sofern das Symmetriesignal Ssy eine logische 1 aufweist. Nur, wenn der Einfach-Erdschluss auch nach Ablauf der Zeitspanne T noch vorliegt (SEA=1, TEA=0), wird die Blockierung aufgehoben und die Signale SI1 bis SI3 können zur Impedanzsignal-Auswerteeinrichtung 507 gelangen. Liegt - wie dies im Falle eines Erdschlusswischers der Fall ist - nach Ablauf der Zeitspanne T kein Einfach-Erdschluss mehr vor (SEA=0, TEA=1), so wird die Blockierung aufgehoben, aber kein Fehlersignal für einen Einfach-Erdschluss erzeugt. Die Blockierung erfolgt dabei - wie erläutert - nur im Falle einer Symmetrie der verketteten Spannungen.

Wenn das Anregesignal Sa eine logische 1 aufweist und wenn keine Blockierung vorliegt, bildet die Schleifenimpedanz-Auswerteinrichtung 310 mit den eingangsseitig anliegenden Strom-und Spannungswerten die Schleifenimpedanzen der Energieübertragungsleitung 35 und vergleicht diese mit einem vorgegebenen Anregebereich. Liegen zwei Leiter-Erde-Schleifenimpedanzen innerhalb des vorgegebenen Anregebereichs, so schließt die Schleifenimpedanz-Auswerteinrichtung 310 darauf, dass die jeweiligen Phasenleiter vom Doppelerdschluss betroffen sind und erzeugt ausgangsseitig ein entsprechendes Fehlersignal F, das diese beiden Phasenleiter als vom Doppelerdschluss betroffen kennzeichnet.

Zusammenfassend ist somit festzustellen, dass die Spannungszeiger-Auswerteinrichtung 305 und die Schleifenimpedanz-Auswerteinrichtung 310 der Fehlersignal-Erzeugungseinrichtung 25 unterschiedlich arbeiten. Konkret erzeugt die Spannungszeiger-Auswerteinrichtung 305 ihr Fehlersignal, wenn die verketteten Phasenspannungen des Energieübertragungsnetzes relativ zueinander eine vorgegebene amplitudenbezogene Unsymmetrieschwelle überschreiten und die Nullspannung zu groß ist. In diesem Fall wird also das Fehlersignal F zur Kennzeichnung der vom Doppelerdschluss betroffenen Phasenleiter auf der Basis spannungsbezogener Messwerte gebildet. Die Bestimmung der fehlerbehafteten Phasenleiter erfolgt dabei wie im Zusammenhang mit der Figur 5 beschrieben. Sind die verketteten Phasenspannungen des Energieübertragungsnetzes 40 jedoch symmetrisch zueinander, so erfolgt die Ermittlung der vom Erdschluss betroffenen Phasenleiter in anderer Weise, nämlich auf der Basis der Schleifenimpedanzwerte, die sich bezüglich der Energieübertragungsleitung 35 aus den Strom- und Spannungsmesswerten errechnen lassen.

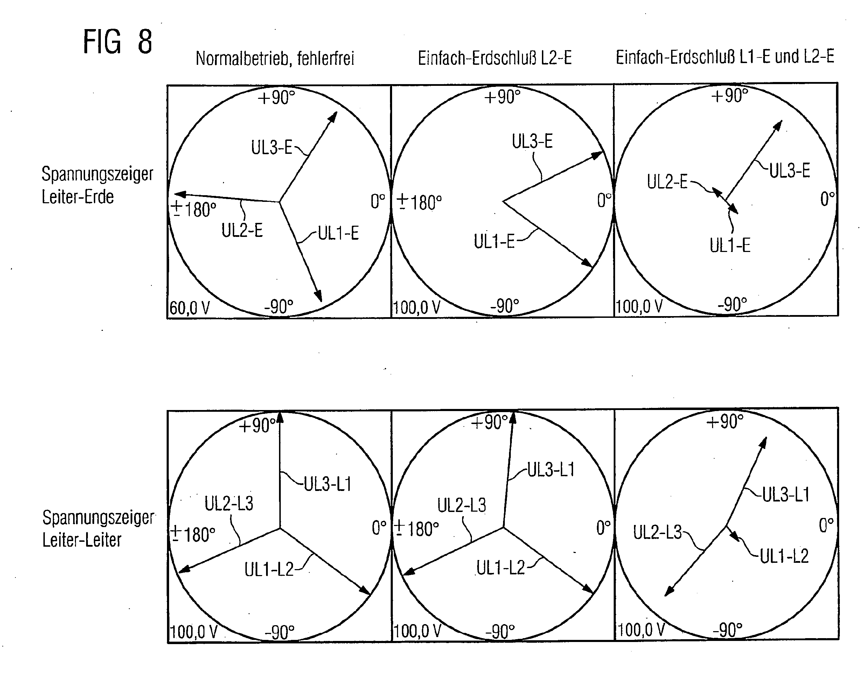

Die Figur 8 zeigt beispielhaft, wie Leiter-Erde-Spannungszeiger und verkettete Spannungszeiger im fehlerfreien Zustand, im Falle eines Einfach-Erdschlusses (z. B. Phasenleiter L2 betroffen) oder im Falle eines Doppelerdschlusses (z. B. Phasenleiter L1 und L2 betroffen) aussehen können. Man erkennt, dass im Falle eines Einfach-Erdschlusses die verketteten Spannungen noch symmetrisch sind und dass eine Unsymmetrie erst im Falle eines Doppel-Erdschlusses auftritt. Auch lässt sich erkennen, dass im Falle eines Einfach-Erdschlusses nur eine einzige Leiter-Erde-Spannung sehr klein wird und dass im Falle eines Doppelerdschlusses zwei Leiter-Erde-Spannungen gegenüber der nicht vom Erdschluss betroffenen Leiter-Erde-Spannung klein werden. Im letztgenannten Falle kommt es auch zu einer Erhöhung der Spannungsamplitude des "gesunden" Phasenleiters um den Faktor $\sqrt{3}$.

Die im Zusammenhang mit den Figuren 1 bis 6 gezeigten Funktionsblöcke des Schutzgerätes 10 können hardwaremäßig oder softwaremäßig realisiert sein, beispielsweise durch eine entsprechende Programmierung einer oder mehrerer Mikroprozessoranordnungen innerhalb des Schutzgerätes.

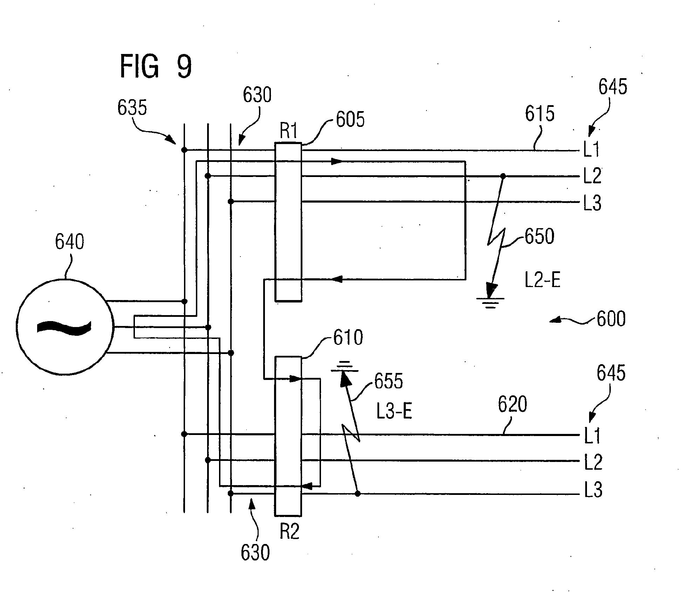

In der Figur 9 erkennt man eine Anordnung 600 mit zwei Schutzgeräten 605 und 610, beispielsweise solchen, wie sie im Zusammenhang mit den Figuren 1 bis 8 beschrieben sind.

Das erste Schutzgerät 605 ist an eine erste Stichleitung 615 und das zweite Schutzgerät 610 an eine zweite Stichleitung 620 angeschlossen. Die beiden Stichleitungen 615 und 620 gehören zu einem gelöschten oder gegenüber Erdpotential isolierten dreiphasigen Energieübertragungsnetz und sind mit ihrem einen Leitungsende 630 über eine Sammelschiene 635 miteinander sowie mit einem Generator 640 verbunden. An das jeweils andere Leitungsende 645 sind jeweils Verbraucher angeschlossen, die der Übersichtlichkeit halber in der Figur 9 nicht dargestellt sind.

Jedes der zwei Schutzgeräte 605 und 610 überwacht seine zugeordnete Stichleitung 615 bzw. 620 auf das Vorliegen eines Doppelerdschlusses, wie dies oben beschrieben wurde. Stellen die beiden Schutzgeräte unabhängig voneinander fest, dass ein Erdschluss 650 im Bereich der ersten Stichleitung 615 und ein weiterer Erdschluss 655 im Bereich der zweiten Stichleitung 620 aufgetreten ist, so prüfen sie, welche Phasen von dem Doppelerdschluss betroffen sind.

Sind, wovon in der Figur 9 beispielhaft ausgegangen wird, die Phasen L2 und L3 mit Erde verbunden, stellen dies also beide Schutzgeräte fest. In beiden Schutzgeräten ist, beispielsweise in einem elektronischen Speicher, hinterlegt, welche Phasen bevorzugt abzuschalten sind: Es gibt also eine bevorzugte Abschaltreihenfolge.

Unter der Annahme, dass in beiden Schutzgeräten hinterlegt ist, dass die Phase L1 vor den Phasen L2 und L3 und die Phase L2 vor der Phase L3 abgeschaltet werden soll, so wird nur das erste Schutzgerät 605 seine Stichleitung 615 abschalten; denn die Phase L2, die zu der Stichleitung 615 gehört, soll vor der Phase L3 abgeschaltet werden, die zu der Stichleitung 620 gehört.

Das zweite Schutzgerät 610 wird zunächst nichts unternehmen, da bei seiner Stichleitung 620 die Phase L3 von dem Erdschluss betroffen ist und nicht die Phase L2. Das zweite Schutzgerät wird somit eine vorgegebene Wartezeit abwarten, damit das erste Schutzgerät 605 den Doppelerdschluss abschalten kann. Sobald das erste Schutzgerät seine Stichleitung 615 abgeschaltet hat, liegt kein Doppelerdschluss mehr vor und die zweite Stichleitung kann trotz Erdschluss weiterbetrieben werden, weil die Stichleitungen zu einem zu einem gelöschten oder gegenüber Erdpotential isolierten dreiphasigen Energieübertragungsnetz gehören, das bei einphasigen Erdschlüssen durchaus weiterbetrieben werden kann.

Nur wenn das erste Schutzgerät 605 defekt ist und nichts unternimmt, wird das zweite Schutzgerät 610 nach Ablauf der vorgegebenen Wartezeit seine Stichleitung 615 abschalten.

**Patentansprüche**

1. Verfahren zum Überwachen eines gelöschten oder gegenüber Erdpotential isolierten dreiphasigen Energieübertragungsnetzes (40) im Hinblick auf das Vorliegen eines Erdschlusses, **dadurch gekennzeichnet,**

    - **dass** überprüft wird, ob die verketteten Phasenspannungen des Energieübertragungsnetzes (40) relativ zueinander eine vorgegebene amplitudenbezogene Unsymmetrie-Schwelle überschreiten,
    - **dass** ein entsprechendes Symmetriesignal (Ssy) gebildet wird, das eine Symmetrie oder Unsymmetrie der verketteten Phasenspannungen anzeigt, und
    - **dass** dieses Symmetriesignal (Ssy) bei der weiteren Überwachung im Hinblick auf das Vorliegen eines Erdschlusses herangezogen wird.

2. Verfahren nach Anspruch 1,
    **dadurch gekennzeichnet,**

    - **dass** überprüft wird, ob die Nullspannung (3U0) des Energieübertragungsnetzes (40) einen vorgegebenen Nullspannungs-Schwellenwert (U0min) überschreitet, und
    - **dass** ein Anregesignal (Sa, S1) erzeugt wird, wenn die Nullspannung den Nullspannungs-Schwellenwert überschreitet und die verketteten Phasenspannungen die Unsymmetrie-Schwelle überschreiten.

3. Verfahren nach Anspruch 2,
    **dadurch gekennzeichnet,**
    **dass** der Nullstrom (3I0) gemessen wird und das Anregesignal (Sa) zusätzlich auch dann erzeugt wird, wenn der Nullstrom (3I0) einen vorgegebenen Nullstrom-Schwellenwert überschreitet.

4. Verfahren nach Anspruch 1, 2 oder 3,
    **dadurch gekennzeichnet,**
    **dass** die Amplituden der drei verketteten Phasenspannungen bestimmt werden und dass die vorgegebene amplitudenbezogene Unsymmetrie-Schwelle als überschritten angesehen wird, wenn die Differenz zwischen der größten Amplitude (Amax) und der kleinsten Amplitude (Amin) eine vorgegebene Differenzschwelle überschreitet.

5. Verfahren nach einem der vorangehenden Ansprüche 3-4,
    **dadurch gekennzeichnet,**

    - **dass** geprüft wird, ob eine Stromwandlersättigung bezüglich zumindest eines zur Bildung des Nullstroms herangezogenen Phasenleiterstrommesswerts aufgetreten ist, und
    - **dass** im Falle einer Stromwandlersättigung das Erzeugen des Anregesignals (Sa) unterdrückt wird, sofern ausschließlich das Überschreiten des Nullstrom-Schwellenwerts durch den Nullstrom das Anregesignal (Sa) auslösen würde.

6. Verfahren nach Anspruch 5,
    **dadurch gekennzeichnet,**
    **dass** der vorgegebene Nullstrom-Schwellenwert eine variable Größe ist, die in Abhängigkeit von der Größe der Phasenstrommesswerte adaptiv verändert wird.

7. Verfahren nach Anspruch 6,
    **dadurch gekennzeichnet,**
    **dass** der vorgegebene Nullstrom-Schwellenwert umso größer eingestellt wird, je größer die Phasenstrommesswerte sind.

8. Verfahren nach einem der vorangehenden Ansprüche 6-7,
    **dadurch gekennzeichnet,**

    - **dass** der Nullstrom-Schwellenwert durch eine mathematische Funktion definiert wird, bei der die gemessenen Phasenstrommesswerte Parameter bilden.

9. Verfahren nach einem der vorangehenden Ansprüche,
    **dadurch gekennzeichnet,**

- **dass** geprüft wird, ob ein Doppelerdschluss vorliegt,
- **dass** die beiden vom Doppelerdschluss betroffenen Phasenleiter des Energieübertragungsnetzes (40) ermittelt werden und
- **dass** ein diese beiden Phasenleiter kennzeichnendes Fehlersignal (F) erzeugt wird.

10. Verfahren nach Anspruch 9,
    **dadurch gekennzeichnet,**
    **dass** die beiden fehlerbehafteten Phasenleiter sofort ermittelt werden und das entsprechende Fehlersignal (F) sofort erzeugt wird, wenn die Nullspannung (3U0) den vorgegebenen Nullspannungs-Schwellenwert (U0min) überschreitet und wenn außerdem die verketteten Phasenspannungen zueinander die vorgegebene Unsymmetrie-Schwelle überschreiten.

11. Verfahren nach einem der vorangehenden Ansprüche 9-10,
    **dadurch gekennzeichnet,**
    **dass**, wenn die Nullspannung (3U0) den vorgegebenen Nullspannungs-Schwellenwert (U0min) überschreitet und die verketteten Phasenspannungen zueinander die vorgegebene Unsymmetrie-Schwelle überschreiten, das Fehlersignal erzeugt wird, indem die Amplituden der verketteten Spannungen und die Amplituden der einzelnen Phasenleiter-Erde-Spannungen ermittelt werden, wobei zwei der drei Phasenleiter als fehlerbehaftet identifiziert werden,

    - wenn die Amplitude ihrer verketteten Spannung die kleinste der drei ermittelten Amplituden der verketteten Spannungen bildet und
    - wenn außerdem die Amplitude ihrer Phasenleiter-Erde-Spannungen kleiner als die des dritten fehlerfreien Phasenleiters ist.

12. Verfahren nach einem der vorangehenden Ansprüche 9-11,
    **dadurch gekennzeichnet,**
    **dass**, wenn die Nullspannung (3U0) den vorgegebenen Nullspannungs-Schwellenwert (U0min) unterschreitet oder die verketteten Phasenspannungen zueinander die vorgegebene Unsymmetrie-Schwelle unterschreiten, das Fehlersignal für einen Doppelerdschluss erzeugt wird, wenn zwei Leiter-Erde-Schleifenimpedanzen innerhalb und eine außerhalb eines vorgegebenen Anregebereichs liegen.

13. Verfahren nach einem der vorangehenden Ansprüche 1 bis 8,
    **dadurch gekennzeichnet,**
    **dass** geprüft wird, ob ein Einphasen-Erdschluss vorliegt und ein entsprechendes Fehlersignal (F) im Falle eines detektierten Einphasen-Erdschlusses erzeugt wird.

14. Verfahren nach Anspruch 13,
    **dadurch gekennzeichnet,**
    **dass**, wenn ein Einphasen-Erdschluss detektiert wird, für eine vorgegebene Zeitdauer (T) zunächst ein Sperrsignal (S3) erzeugt wird, das eine Ausgabe des Fehlersignals für diese Zeitdauer blockiert.

15. Verfahren nach einem der vorangehenden Ansprüche 9-12,
    **dadurch gekennzeichnet,**
    **dass** bei Vorliegen des Fehlersignals (F) für einen Doppelerdschluss, bei dem ein erster Erdschluss (650) auf einer ersten dreiphasigen Leitung (615) und ein zweiter Erdschluss (635) auf einer mit der ersten Leitung verbundenen zweiten dreiphasigen Leitung (620) aufgetreten ist, von den betroffenen Leitungen diejenige abgeschaltet wird, deren vom Fehler betroffener Phasenleiter gemäß einer vorgegebenen Phasenleiter-Vorzugsliste bevorzugt abzuschalten ist, und dass die andere Leitung zumindest zunächst unabgeschaltet bleibt.

16. Schutzgerät (10) mit einer Prüfeinrichtung (20) zum Überwachen eines gelöschten oder gegenüber Erdpotential isolierten dreiphasigen Energieübertragungsnetzes (40) im Hinblick auf das Vorliegen eines Erdschlusses,
    **dadurch gekennzeichnet,**
    **dass** die Prüfeinrichtung (20) eine Symmetrie-Prüfeinrichtung (105) umfasst, die derart ausgestaltet ist,

    - **dass** sie überprüft, ob die verketteten Phasenspannungen des Energieübertragungsnetzes relativ zueinander eine vorgegebene amplitudenbezogene Unsymmetrie-Schwelle überschreiten,
    - **dass** sie ein entsprechendes Symmetriesignal (Ssy) bildet, das eine Symmetrie oder Unsymmetrie der verketteten Phasenspannungen anzeigt, und
    - **dass** sie dieses Symmetriesignal bei der weiteren Überwachung heranzieht.

17. Verfahren nach Anspruch 1 zum Betreiben einer Anordnung mit zwei Schutzgeräten gemäß Anspruch 16, die an unterschiedliche Leitungen (615, 620) eines Energieübertragungsnetzes angeschlossen sind, wobei jedes der zwei Schutzgeräte seine zugeordnete Leitung auf das Vorliegen eines Doppelerdschlusses gemäß einem Verfahren nach einem der voranstehenden Ansprüche überwacht und wobei im Falle, dass eine vom Doppelerdschluss betroffene Phase zu einer der beiden Leitungen und die andere vom Doppelerdschluss betroffene Phase zu der anderen Leitung gehört, dasjenige der zwei Schutzgeräte seine zugeordnete Leitung abschaltet, zu dem die bevorzugt abzuschaltende fehlerbehaftete Phase gemäß einer den beiden Schutzgeräten vorgegebenen Phasenabschaltreihenfolge gehört.

**Claims**

1. Method for monitoring a three-phase power transmission system (40) which is resonant-earthed or is isolated from earth potential for the presence of an earth fault
**characterized**

> - **in that** a check is performed to ascertain whether the line-to-line phase voltages of the power transmission system (40) relative to one another exceed a predetermined amplitude-related imbalance threshold,
> - **in that** a corresponding balance signal (Ssy) is formed which indicates a balance or imbalance in the line-to-line phase voltages, and
> - **in that** this balance signal (Ssy) is used in the further monitoring for the presence of an earth fault.

2. Method according to Claim 1,
**characterized**

> - **in that** a check is performed to ascertain whether the zero voltage (3U0) of the power transmission system (40) exceeds a predetermined zero voltage threshold value (U0min), and
> - **in that** a trigger signal (Sa, S1) is generated if the zero voltage exceeds the zero voltage threshold value and the line-to-line phase voltages exceed the imbalance threshold.

3. Method according to Claim 2,
**characterized**
**in that** the zero current (3I0) is measured and the trigger signal (Sa) is additionally also generated when the zero current (3I0) exceeds a predetermined zero current threshold value.

4. Method according to Claim 1, 2 or 3,
**characterized**
**in that** the amplitudes of the three line-to-line phase voltages are determined, and in that the predetermined amplitude-related imbalance threshold is considered as having been exceeded if the difference between the greatest amplitude (Amax) and the smallest amplitude (Amin) exceeds a predetermined differential threshold.

5. Method according to one of the preceding Claims 3 - 4
**characterized**

> - **in that** a check is performed to ascertain whether current transformer saturation has occurred with respect to at least one phase conductor measurement value used for forming the zero current, and
> - **in that**, in the event of current transformer saturation, the generation of the trigger signal (Sa) is suppressed if only the event of the zero current threshold value being exceeded by the zero current would activate the trigger signal (Sa).

6. Method according to Claim 5,
**characterized**
**in that** the predetermined zero current threshold value is a variable quantity, which changes adaptively as a function of the magnitude of the phase current measurement values.

7. Method according to Claim 6,
**characterized**
**in that** the greater the phase current measurement values are, the greater the predetermined zero current threshold value is said to be.

8. Method according to one of the preceding Claims 6 - 7,
**characterized**

> - **in that** the zero current threshold value is defined by a mathematical function, in which the measured phase current measurement values form parameters.

9. Method according to one of the preceding claims,
**characterized**

> - **in that** a check is performed to ascertain whether there is a double earth fault,
> - **in that** the two phase conductors of the power transmission system (40) which are affected by the double earth fault are determined and
> - **in that** a fault signal (F) identifying these two phase conductors is generated.

10. Method according to Claim 9,
**characterized**
**in that** the two faulty phase conductors are determined immediately and the corresponding fault signal (F) is generated immediately if the zero voltage (3U0) exceeds the predetermined zero voltage threshold value (U0min) and if, in addition, the line-to-line phase voltages with respect to one another exceed the predetermined imbalance threshold.

11. Method according to one of the preceding Claims 9 - 10,
**characterized**
**in that**, if the zero voltage (3U0) exceeds the predetermined zero voltage threshold value (U0min) and the line-to-line phase voltages with respect to one another exceed the predetermined imbalance threshold, the fault signal is generated by virtue of the amplitudes of the line-to-line voltages and the amplitudes of the individual phase conductor-to-earth voltages being determined, with two of the three phase conductors being identified as faulty,

    - if the amplitude of their line-to-line voltage forms the smallest of the three determined amplitudes of the line-to-line voltages, and
    - in addition, the amplitude of their phase conductor-to-earth voltages is less than that of the third faulty phase conductor.

12. Method according to one of the preceding Claims 9 - 11,
**characterized**
**in that** if the zero voltage (3U0) falls below the predetermined zero voltage threshold value (U0min) or the line-to-line phase voltages with respect to one another fall below the predetermined imbalance threshold, the fault signal is generated for a double earth fault if two phase-to-earth loop impedances are inside and one is outside a predetermined trigger range.

13. Method according to one of the preceding Claims 1 to 8,
**characterized**
**in that** a check is performed to ascertain whether a single-phase earth fault is present, and a corresponding fault signal (F) is generated in the event of a detected single-phase earth fault.

14. Method according to Claim 13,
**characterized**
**in that** if a single-phase earth fault is detected, first a blocking signal (S3) is generated for a predetermined period of time (T), which blocking signal blocks the output of the fault signal for this period of time.

15. Method according to one of the preceding Claims 9 - 12,
**characterized**
**in that**, in the event of the presence of the fault signal (F) for a double earth fault, in which a first earth fault (650) has occurred on a first three-phase line (615) and a second earth fault (635) has occurred on a second three-phase line (620), which is connected to the first line, that line of the affected lines whose phase conductor is affected by the fault is preferably intended to be disconnected in accordance with a predetermined list of phase conductor preferences, and in that the other line remains undisconnected, at least initially.

16. Protection device (10) with a test device (20) for monitoring a three-phase power transmission system (40) which is resonant-earthed or is isolated from earth potential for the presence of an earth fault,
**characterized**
**in that** the test device (20) comprises a balance test device (105), which is designed in such a way

    - that it performs a check to ascertain whether the line-to-line phase voltages of the power transmission system relative to one another exceed a predetermined amplitude-related imbalance threshold,
    - that it forms a corresponding balance signal (Ssy), which indicates a balance or imbalanced of the line-to-line phase voltages, and
    - that it uses this balance signal for the further monitoring.

17. Method according to Claim 1 for operating an arrangement with two protection devices according to Claim 16, which are connected to different lines (615, 620) of a power transmission system, each of the two protection devices monitoring its own associated line for the presence of a double earth fault in accordance with a method according to one of the preceding claims, and in the event that a phase affected by the double earth fault belongs to one of the two lines and the other phase affected by the double earth fault belongs to the other line, that protection device of the two protection devices disconnects an associated line to which the faulty phase which is preferably to be disconnected in accordance with a phase disconnection sequence predetermined for the two protection devices belongs.

**Revendications**

1. Procédé de contrôle d'un réseau ( 40 ) de transport d'énergie triphasé, inutilisé ou isolé par rapport au potentiel de terre, en ce qui concerne la présence d'une fuite à la terre,
**caractérisé**

    - **en ce qu'**on contrôle si les tensions de phase composées du réseau ( 40 ) de transport d'énergie dépassent l'une par rapport à l'autre un seuil de dissymétrie prescrit rapporté en amplitude,
    - **en ce qu'**on forme un signal ( Ssy ) de symétrie correspondant, qui indique une symétrie ou une dissymétrie des tensions de phase composées, et
    - **en ce qu'**on tire parti de ce signal ( Ssy ) de symétrie lors du contrôle à venir en ce qui concerne la présence d'une fuite à la terre.

2. Procédé suivant la revendication 1, **caractérisé**

- **en ce qu'**on contrôle si la tension ( 3U0 ) homopolaire du réseau ( 40 ) de transport d'énergie dépasse une valeur ( U0min ) de seuil prescrite de tension homopolaire, et
- **en ce qu'**on produit un signal ( Sa, S1 ) d'excitation si le seuil de tension homopolaire et si les tensions de phases composées dépassent le seuil de dissymétrie.

3. Procédé suivant la revendication 2, **caractérisé**
**en ce qu'**on mesure le courant ( 3I0 ) homopolaire et on produit le signal ( Sa ) d'excitation supplémentairement aussi lorsque le courant ( 3I0 ) homopolaire dépasse une valeur de seuil prescrite de courant homopolaire.

4. Procédé suivant la revendication 1, 2 ou 3, **caractérisé**
**en ce qu'**on détermine les amplitudes des trois tensions de phase composées et en ce qu'on considère comme dépassé le seuil de dissymétrie prescrit rapporté à l'amplitude, si la différence entre l'amplitude ( Amax ) la plus grande et l'amplitude ( Amin ) la plus petite dépasse un seuil de différence prescrit.

5. Procédé suivant l'une des revendications précédentes 3 à 4, **caractérisé**

- **en ce qu'**on contrôle s'il s'est produit une saturation de transformateur de courant par rapport à au moins une valeur de mesure du courant d'un conducteur de phase dont on a tiré parti pour la formation du courant homopolaire, et
- **en ce que**, dans le cas d'une saturation de convertisseur de courant, on supprime la production du signal ( Sa ) d'excitation, pour autant que le dépassement de la valeur de seuil du courant homopolaire aurait déclenché exclusivement le signal ( Sa ) d'excitation.

6. Procédé suivant la revendication 5, **caractérisé**
**en ce que** la valeur de seuil prescrite de courant homopolaire est une grandeur variable, qui est modifiée de manière adaptative en fonction de la grandeur des valeurs de mesure des courants de phase.

7. Procédé suivant la revendication 6, **caractérisé**
**en ce qu'**on règle la valeur de seuil prescrite du courant homopolaire à une valeur d'autant plus grande que les valeurs de courant de phase sont plus grandes.

8. Procédé suivant l'une des revendications précédentes 6 à 7, **caractérisé**

- **en ce qu'**on définit la valeur de seuil de courant homopolaire par une fonction mathématique, dans laquelle les valeurs de mesure de phases mesurées forment des paramètres.

9. Procédé suivant l'une des revendications précédentes, **caractérisé**

- **en ce qu'**on contrôle s'il y a une double fuite à la terre,
- **en ce qu'**on détermine les deux conducteurs de phase concernés par la double fuite à la terre du réseau ( 40 ) de transport d'énergie et
- **en ce qu'**on produit un signal ( F ) de défaut caractérisant l'un de ces deux conducteurs de phase.

10. Procédé suivant la revendication 9, **caractérisé**

- **en ce qu'**on détermine immédiatement les deux conducteurs de phase souffrant d'un défaut et en ce qu'on produit immédiatement le signal ( F ) de défaut correspondant, lorsque la tension ( 3U0 ) homopolaire de la valeur ( U0min ) de seuil prescrite de tension homopolaire est dépassée et lorsqu'en outre les tensions de phase composées dépassent l'une par rapport à l'autre le seuil de dissymétrie prescrit.

11. Procédé suivant l'une des revendications précédentes 9 à 10, **caractérisé**
**en ce que**, lorsque la tension ( 3U0 ) homopolaire de la valeur ( U0min ) de seuil prescrite de tension homopolaire est dépassée et lorsque les tensions de phase composées dépassent les unes par rapport aux autres le seuil de dissymétrie prescrit, on produit le signal de défaut en déterminant les amplitudes des tensions composées et les amplitudes des tensions conducteurs de phase-terre individuelles, deux des trois conducteurs de phase étant identifiés comme souffrant d'un défaut,

- lorsque l'amplitude de leurs tensions composées forme la plus petite des trois amplitudes déterminées des tensions composées et
- lorsqu'en outre l'amplitude de leurs tensions conducteurs de phase-terre est plus petite que celle du troisième conducteur de phase sans défaut.

**12.** Procédé suivant l'une des revendications précédentes 9 à 11,
**caractérisé**
**en ce que**, lorsque la tension ( 3U0 ) homopolaire dépasse la valeur ( U0min ) de seuil de tension homopolaire prescrite ou lorsque les tensions de phase composées passent entre elles en dessous du seuil de dissymétrie prescrit, on produit le signal de défaut pour une fuite à la terre double, lorsque deux impédances de boucle conducteur-terre se trouvent à l'intérieur et l'une à l'extérieur d'une plage d'excitation prescrite.

**13.** Procédé suivant l'une des revendications précédentes 1 à 8, **caractérisé**
**en ce qu'**on contrôle s'il y a une fuite à la terre d'une seule phase et on produit un signal ( F ) correspondant de défaut,
si on détecte une fuite à la terre d'une seule phase.

**14.** Procédé suivant la revendication 13,
**caractérisé**
**en ce que**, lorsqu'on détecte une fuite à la terre d'une seule phase, on produit pendant une durée ( T ) prescrite d'abord un signal ( S3 ) d'arrêt, qui bloque une sortie du signal de défaut pendant cette durée.

**15.** Procédé suivant l'une des revendications précédentes 9 à 12,
**caractérisé**
**en ce qu'**en présence du signal ( F ) de défaut pour une double fuite à la terre, dans lequel une première fuite ( 650 ) à la terre est apparue sur une première ligne ( 615 ) triphasée et une deuxième fuite ( 635 ) à la terre est apparue sur une deuxième ligne ( 620 ) triphasée reliée à la première ligne, on met hors circuit parmi les lignes concernées celle dont le conducteur de phase concerné par le défaut doit être mise hors circuit, de préférence suivant une liste de préférence prescrite de conducteur de phase, et en ce qu'on laisse l'autre ligne, au moins dans un premier temps, sans la mettre hors circuit.

**16.** Appareil ( 10 ) de protection comprenant un dispositif ( 20 ) de contrôle d'un réseau ( 40 ) de transport d'énergie, triphasée inutilisé ou isolé par rapport au potentiel de terre, pour ce qui concerne la présence d'une fuite à la terre,
**caractérisé**
**en ce que** le dispositif ( 20 ) de contrôle comprend un dispositif ( 105 ) de contrôle de symétrie, qui est tel

- qu'il contrôle si les tensions de phase composées du réseau de transport d'énergie dépassent les unes par rapport aux autres un seuil de dissymétrie prescrit rapporté aux amplitudes,
- qu'il forme un signal ( Ssy ) de symétrie correspondant, qui indique une symétrie ou une dissymétrie des tensions de phase composées, et
- qu'il tire parti de ce signal de symétrie pour le contrôle ultérieur.

**17.** Procédé suivant la revendication 1 pour faire fonctionner un dispositif ayant deux appareils de protection suivant la revendication 16, qui sont raccordés sur des lignes ( 615, 620 ) différentes d'un réseau de transport d'énergie, dans lequel chacun des deux appareils de protection contrôle sa ligne associée pour ce qui concerne la présence d'une double fuite à la terre selon un procédé suivant l'une des revendications précédentes et dans lequel, dans le cas où une phase concernée par la double fuite à la terre appartient à l'une des deux lignes et l'autre phase concernée par la double fuite à la terre appartient à l'autre ligne, met hors circuit la ligne associée de celui des deux appareils de protection auquel appartient la phase souffrant d'un défaut à mettre hors circuit, de préférence suivant une succession de mises hors circuit des phases prescrite aux deux appareils de protection.

FIG 1

EP 1 984 995 B1

## FIG 2

## FIG 3

# FIG 4

Ssy

Sa

3U0

UL1-L2

UL2-L3

UL3-L1

UL1-E

UL2-E

UL3-E

IL3

IL2

IL1

3I0

305

F

310

25

# FIG 5

## FIG 6

Ssy
Sa
UL1-E
UL2-E
UL3-E
IL3
IL2
IL1
3I0

505

Ssy

310

506

508

6

SI1-SI6

SEA

510

0 1 T

TEA

520

&

S3

525

&

6

6

507

F

## FIG 7

Im(Z)

A

Re(Z)

# FIG 8

Normalbetrieb, fehlerfrei        Einfach-Erdschluß L2-E        Einfach-Erdschluß L1-E und L2-E

Spannungszeiger
Leiter-Erde

Spannungszeiger
Leiter-Leiter

EP 1 984 995 B1

FIG 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10215025 A1

- JP 2004015862 A

**In der Beschreibung aufgeführte Nicht-Patentliteratur**

- *Patent Abstracts of Japan,* 05. Dezember 2003, vol. 2003 (12